# EUROPEAN PATENT APPLICATION

(11) **EP 4 358 128 A1**
(43) Date of publication of application: **24.04.2024**
(21) Application number: 22824703.7
(22) Date of filing: 09.05.2022
(51) Int. Cl.: H01L 23/36, H01L 25/07, H01L 25/18

(54) **POWER SEMICONDUCTOR MODULE**

(30) Priority: 17.06.2021 JP 2021100765
(71) Applicant: Hitachi Power Semiconductor Device, Ltd., Hitachi-shi, Ibaraki 319-1221 (JP)
(72) Inventor: NISHIMORI, Hitoshi, Tokyo 100-8280 (JP); HORIUCHI, Keisuke, Tokyo 100-8280 (JP); NAKAZATO, Norio, Tokyo 100-8280 (JP); KAWASE, Daisuke, Hitachi-shi, Ibaraki 319-1221 (JP); SASAKI, Koji, Hitachi-shi, Ibaraki 319-1221 (JP)
(74) Representative: Mewburn Ellis LLP
(86) International application number: PCT/JP2022/019698
(87) International publication number: WO 2022/264709

(57) **Abstract**

The present invention can provide a power semiconductor module in which space for storing heat-conductive grease between a heat sink and a cooler is ensured while ensuring sufficient contact area between the heat sink and the cooler. The power semiconductor module of the present invention is characterized by comprising a base plate (15), a semiconductor chip (11) mounted on a first main surface of the base plate, and a heat sink (22) connected to a second main surface of the base plate (15), wherein: a chamfered part is provided at an end portion of at least one side of the second main surface; and, when the cross section of the base plate (15) is viewed in a state in which the base plate (15) is fixed to the heat sink (22), the slope of the second main surface of the base plate (15) is discontinuous at the boundary between the chamfered part and an area of the second main surface other than the chambered part, and the angle between the bottom surface (15e) of the chamfered part of the base plate (15) and the surface on the side of the heat sink (22) where the base plate (15) is fixed is 5° to 30°.

## Description

### Technical Field

The present invention relates to a power semiconductor module.

### Background Art

A structure of a conventional semiconductor module is described in, for example, PTL 1. In the semiconductor module of PTL 1, an insulating substrate 4 is installed on an upper surface of a heat dissipation plate 2, and a semiconductor chip 6 is installed on an upper surface of the insulating substrate 4. The heat dissipation plate 2 is installed on a cooler 12, and a thermal conductive grease 14 is applied between the heat dissipation plate 2 and cooler the 12. PTL 1 discloses that the heat dissipation plate 2 and the cooler 12 can be reliably brought into contact with each other via the thermal conductive grease 14 by forming a portion of the heat dissipation plate 2 on the cooler 12 side into a convex shape.

### Citation List

### Patent Literature

PTL 1: JP 2005-39081 A

### Summary of Invention

### Technical Problem

However, it is unclear whether the structure disclosed in PTL 1 is in a state after the heat dissipation plate 2 and the cooler 12 are fixed by screw fastening or a state before screw fastening. However, if the structure disclosed in PTL 1 described above is in the state after the heat dissipation plate 2 and the cooler 12 are fixed by screw fastening, it is considered that a gap is generated between the cooler 12 and the heat dissipation plate 2 under a semiconductor chip 6, and it is not possible to efficiently dissipate heat generated from the semiconductor chip 6 to the cooler 12 via the heat dissipation plate 2.

In addition, if the structure in PTL 1 is in the state before the heat dissipation plate 2 and the cooler 12 are screw-fastened together, the heat dissipation plate 2 is mechanically warped by the screw fastening between the heat dissipation plate 2 and the cooler 12, so that there is an effect of reducing a gap with respect to the cooler 12, and it is possible to expect improvement of heat dissipation. On the other hand, since the gap between the heat dissipation plate 2 and the cooler 12 is reduced by the screw fastening, it is considered that the pump-out in which the thermal conductive grease 14 interposed in the gap between the heat dissipation plate 2 and the cooler 12 is discharged to the outside due to a temperature history when the power semiconductor module is used is likely to occur.

Considering the above circumstances, an object of the present invention is to provide a power semiconductor module that secures a space capable of accumulating a thermal conductive grease disposed between a heat dissipation plate and a cooler while securing a sufficient contact area between the heat dissipation plate and the cooler.

### Solution to Problem

According to an aspect of the present invention for achieving the above object, a power semiconductor module includes a base plate, a semiconductor chip mounted on a first main surface of the base plate, and a heat sink connected to a second main surface of the base plate. A chamfered portion is provided at an end portion of at least one side of the second main surface. In a state where the base plate is fixed to the heat sink, when a cross section of the base plate is viewed, an inclination of the second main surface of the base plate is discontinuous at a boundary between the chamfered portion and a region of the second main surface of the base plate other than the chamfered portion, and an angle formed between a bottom surface of the chamfered portion of the base plate and a surface of the heat sink on a side where the base plate is fixed is 5° or more and 30° or less.

A more specific configuration of the present invention is described in the claims.

### Advantageous Effects of Invention

According to the present invention, it is possible to provide a power semiconductor module that secures a space capable of accumulating a thermal conductive grease disposed between a heat dissipation plate and a cooler while securing a sufficient contact area between the heat dissipation plate and the cooler. This makes it possible to dissipate heat from the power semiconductor chip to the cooler and to suppress an occurrence of a situation in which the thermal conductive grease interposed at an interface between the heat dissipation plate and the cooler leaks to the outside during an operation of the power semiconductor module.

Objects, configurations, and advantageous effects other than those described above will be clarified by the descriptions of the following embodiments.

### Brief Description of Drawings

[FIG. 1A] FIG. 1A is a cross-sectional view of a power semiconductor module in Embodiment 1.
[FIG. 1B] FIG. 1B is an enlarged view of a periphery of a chamfered portion of a base plate in FIG. 1A.
[FIG. 2] FIG. 2 is a top view of the power semiconductor module in Embodiment 1.
[FIG. 3] FIG. 3 is a top view of a power semiconductor module in Embodiment 2.
[FIG. 4] FIG. 4 is a top view of a power semiconductor module in Embodiment 3.
[FIG. 5] FIG. 5 is a top view of a power semiconductor module in Embodiment 4.
[FIG. 6A] FIG. 6A is a cross-sectional view of Embodiment 5.
[FIG. 6B] FIG. 6B is an enlarged view of a periphery of a chamfered portion of a base plate in FIG. 6A.

### Description of Embodiments

Hereinafter, embodiments of a power semiconductor module in the present invention will be described in detail with reference to the drawings.

### Embodiment 1

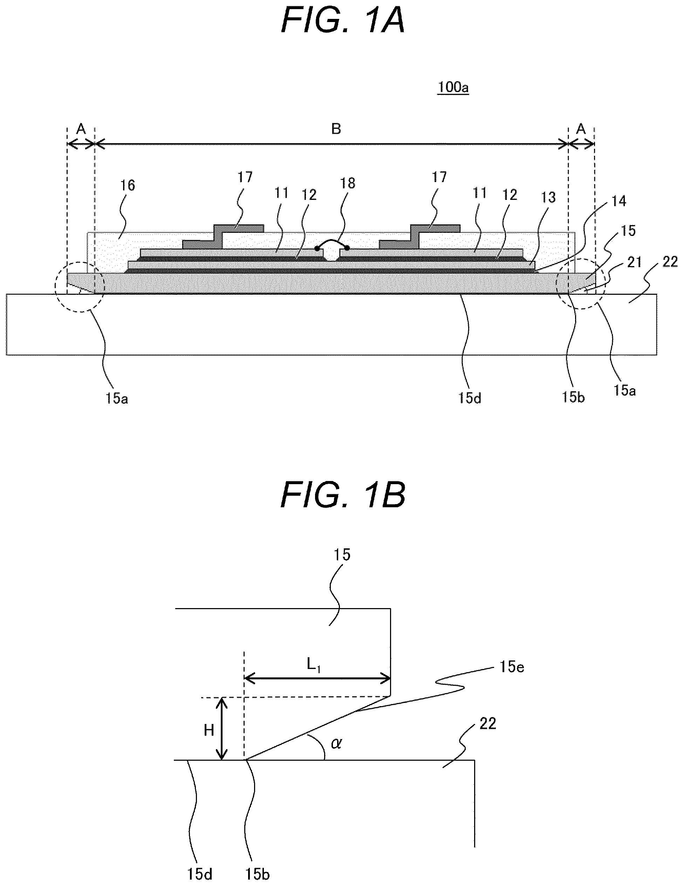

FIG. 1A is a cross-sectional view of a power semiconductor module in Embodiment 1. As illustrated in FIG. 1A, a power semiconductor module 100a in the present invention has a stacked structure in which a power semiconductor chip (simply referred to below as a "semiconductor chip") 11 is mounted on one main surface (first main surface) of a base plate (heat dissipation plate) 15, and a heat sink (cooler) 22 is connected to the other main surface (second main surface) of the base plate 15. Heat generated in the semiconductor chip 11 is transferred to the heat sink 22 via the base plate 15 and dissipated.

A main terminal 17 is connected to the semiconductor chip 11 and exposed to the outside of the power semiconductor module 100a. In addition, semiconductor chips 11 are connected by wire bonding 18.

In the power semiconductor module 100a, for example, a plurality of semiconductor chips 11 is fixed to an insulating substrate 13 via a solder under chip 12, and the insulating substrate 13 is fixed to the base plate 15 via a solder under substrate 14. Note that, although not illustrated, a pattern of a wiring layer is formed on the insulating substrate 13. Note that, although FIG. 1A illustrates an example in which the main terminal 17 is connected to the semiconductor chip 11, the main terminal 17 may be connected to a wiring layer on the insulating substrate 13.

A sealing resin 16 is formed on the base plate 15 to cover the entirety of the semiconductor chip 11, the solder under chip 12, the insulating substrate 13, the solder under substrate 14, and the wire bonding 18 and cover a portion of the main terminal 17. A thermal conductive grease 21 is disposed between the base plate 15 and the heat sink 22.

FIG. 1B is an enlarged view of a periphery of a chamfered portion of the base plate in FIG. 1A. For convenience of description, illustration of the thermal conductive grease 21 illustrated in FIG. 1A is omitted in FIG. 1B. As illustrated in FIG. 1A, the second main surface of the base plate 15 has a surface 15d other than a chamfered portion of the base plate 15, and base-plate chamfered portions 15a at both ends of the surface 15d. A boundary portion between the surface 15d of the second main surface of the base plate 15 other than the chamfered portion and the base-plate chamfered portion 15a is referred to below as a base-plate chamfered portion end 15b.

This will be described with reference to FIG. 1B. In the present embodiment, when the cross section of the base plate 15 is viewed, an angle formed between a bottom surface 15e of the chamfered portion 15a and the surface 15d other than the chamfered portion of the surface of the base plate 15 (second main surface of the base plate 15) on a side fixed to the heat sink 22 is 5° or more and 30° or less, which is equal to an angle α described later. In addition, an inclination of the second main surface of the base plate is discontinuous at a boundary between a region A having the chamfered portion 15a of the base plate and the other region B (see FIG. 1A). In the present embodiment, in a state before the base plate 15 is fixed to the heat sink 22, the surface 15d of the second main surface of the base plate 15 other than the chamfered portion is a flat surface. Therefore, even in a state where the base plate 15 is fixed to the heat sink 22, when the cross section of the base plate 15 is viewed, the angle α formed by the bottom surface 15e of the chamfered portion 15a of the base plate 15 and the surface of the heat sink 22 on the side to which the base plate 15 is fixed (the upper surface of the heat sink 22) is also 5° or more and 30° or less. In addition, the maximum value of a distance H between the bottom surface 15e of the base-plate chamfered portion 15a and the upper surface of the heat sink 22 is 0.5 mm or more and 2.5 mm or less.

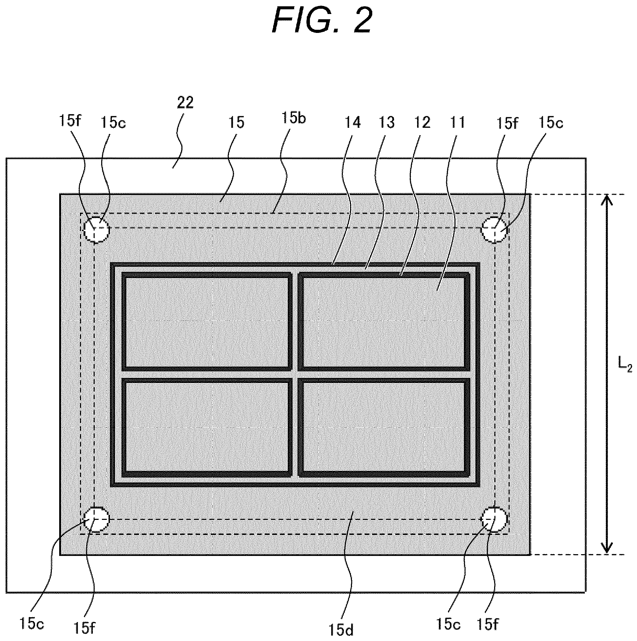

FIG. 2 is a top view of the power semiconductor module in Embodiment 1. The base-plate chamfered portion end 15b illustrated in FIG. 2 is obtained by projecting the base-plate chamfered portion end 15b illustrated in FIG. 1A onto the upper surface of the base plate 15.

In the present embodiment, four semiconductor chips 11 are provided, and the four semiconductor chips 11 are mounted on one insulating substrate. The base-plate chamfered portion end 15b is formed on four sides of the base plate 15. That is, the base-plate chamfered portion 15a is continuously formed on each of the four sides of the surface 15d of the second main surface of the base plate 15 other than the chamfered portion so as to be connected to each other. Further, the base-plate chamfered portion end 15b is located outside each semiconductor chip 11. Since the chamfered portion 15a of the base plate is not in contact with the heat sink 22, the chamfered portion 15a is preferably disposed such that a portion of the chamfered portion 15a, which is not in contact with the heat sink 22, does not overlap with the semiconductor chip 11.

The base plate 15 has a base plate fixing hole 15c for screw-fastening with the heat sink 22. When centers 15f of base plate fixing holes 15c at the four corners are joined to each other by a straight line, the base-plate chamfered portion end 15b is located on an opposite side of the side on which the semiconductor chip 11 is provided. That is, the base-plate chamfered portion end 15b is outside a region surrounded by joining the centers 15f of the base plate fixing holes 15c at the four corners to each other by a straight line. The effect of this configuration will be described later.

The material of the insulating substrate 13 and the base plate 15 is not particularly limited, but a ceramic substrate made of AlN is preferable as the insulating substrate 13, and Cu (copper), Al (aluminum), AlSiC, MgSiC, and the like are preferable as the material of the base plate 15.

Note that the present embodiment discloses an example in which four semiconductor chips 11 are formed on one insulating substrate 13, but a plurality of insulating substrates may be used, or different numbers of semiconductor chips 11 may be used. In addition, although the example in which the base plate fixing holes 15c are at the four corners has been described, fixing holes may be additionally provided other than the four corners.

The operation of the present embodiment will be described below. A structure in which a region A where the chamfered portion 15a of the base plate 15 is provided and a region B where the chamfered portion 15a of the base plate 15 is not provided are connected such that the inclination of the bottom surface of the base plate 15 is discontinuous has been disclosed.

With this structure, since the inclination is discontinuous, a gap is secured between the base plate 15 and the heat sink 22 at the portion that is the base-plate chamfered portion 15a even after the base plate 15 and the heat sink 22 are fixed by screwing or the like. Therefore, even if the thermal conductive grease 21 between the base plate 15 and the heat sink 22 tries to flow out to the outside when the semiconductor chip 11 repeats a cycle of increasing and decreasing the temperature by repeating the operation and stop, it is possible to store the thermal conductive grease 21 in a region sandwiched between the chamfered portion 15a and the heat sink 22. Thus, it is possible to suppress an occurrence of a situation in which the thermal conductive grease 21 flows out of the power semiconductor module 100a.

In addition, if the thermal conductive grease 21 is stored in the region sandwiched between the chamfered portion 15a and the heat sink 22, not air but the thermal conductive grease 21 stored in the sandwiched region is sucked when the temperature rises and the base plate 15 tries to be separated from the heat sink 22. Thus, air hardly enters between the surface 15d of the second main surface of the base plate 15 other than the chamfered portion and the heat sink 22, voids are hardly generated, and thus it is possible to suppress an increase in contact thermal resistance between the base plate 15 and the heat sink 22.

FIG. 1A discloses a structure in which, in a state where the base plate 15 is fixed to the heat sink 22, when the cross section of the base plate 15 is viewed, the angle α formed by the bottom surface 15e of the chamfered portion 15a and the upper surface of the heat sink 22 has an angle of 5° or more and 30° or less, and the maximum value of the distance H between the bottom surface 15e of the chamfered portion 15a and the upper surface of the heat sink 22 is 0.5 mm or more. The effect of this structure will be described. When the size of the power semiconductor module 100a is, for example, 100 mm × 200 mm, and the gap between the base plate 15 and the heat sink 22 is 40 um, the volume of the sandwiched thermal conductive grease 21 is 800 mm3. If 10% of the sandwiched thermal conductive grease 21 may leak due to pump-out, the volume of the thermal conductive grease 21 that may leak is 80 mm3.

In order to store the thermal conductive grease 21 in the region between the base-plate chamfered portion 15a and the heat sink 22 even when the thermal conductive grease 21 corresponding to this volume leaks to one side surface of the power semiconductor module 100a, the volume of a space between the chamfered portion 15a and the heat sink 22 is 100 mm × 5 mm × 0.5 mm ÷ 2 = 125 mm3 if a region having L2 of 100 mm in FIG. 2, L1 of 5 mm (the horizontal dimension of the chamfered portion 15a from the side surface of the base plate 15 to 15b) in FIG. 1B and H of 0.5 mm in FIG. 1B is secured. In addition, the previously assumed amount of the thermal conductive grease 21 can be stored.

The angle α at this time is about 5.7° from L1 of 5 mm and the height H of 0.5 mm. Therefore, the angle α is desirably, for example, 5° or more. In order to secure a certain degree of tolerance with respect to the leaking thermal conductive grease 21, the height H may be set to 2.5 mm and the angle α may be set to 26.6°. However, when the angle further increases, the thermal conductive grease 21 accumulated between the base-plate chamfered portion 15a and the heat sink 22 flows out due to a surface tension relationship, so that the angle α is desirably 30° or less at maximum.

FIG. 2 is a top view of the power semiconductor module in Embodiment 1. Note that, in the power semiconductor module 1 illustrated in FIG. 2, the sealing resin 16 is not illustrated for convenience of description. In this embodiment, the base plate 15 and the heat sink 22 are fixed by bolts (not illustrated) inserted into the base plate fixing holes 15c.

As illustrated in FIG. 2, the present embodiment discloses a configuration in which the base-plate chamfered portion end 15b is located on the outer side than the semiconductor chip 11. With this configuration, heat generated from the power semiconductor chip 11 is dissipated to the heat sink 22 via the solder under chip 12, the insulating substrate 13, the solder under substrate 14, the base plate 15, and the thermal conductive grease 21 having the minimum distance. Thus, a change is small as compared with a heat dissipation path when there is no chamfered portion, and an influence on thermal resistance is small.

Further, the configuration in which the base-plate chamfered portion end 15b is located on the outer side than the center 15f of the base plate fixing hole 15c is disclosed. In a case where the base-plate chamfered portion end 15b reaches the inside of the base plate fixing hole 15c in the periphery of the base plate fixing hole 15c, when the power semiconductor module 1 is screwed, a force pushing down the outside of the base plate fixing hole 15c of the base plate 15, that is, a force lifting up the inside of the base plate fixing hole 15c acts. Thus, a gap is likely to be generated between the surface 15d of the second main surface of the base plate 15 other than the chamfered portion and the heat sink 22, and thermal resistance may be increased. In addition, a large stress may be generated in the vicinity of the base plate fixing hole 15c, and the base plate 15 may be damaged. Therefore, at least in the periphery of the base plate fixing hole 15c, the base-plate chamfered portion end 15b is located on the outer side than the center 15f of the base plate fixing hole 15c, so that it is possible to suppress an increase in thermal resistance and deterioration in reliability.

### Embodiment 2

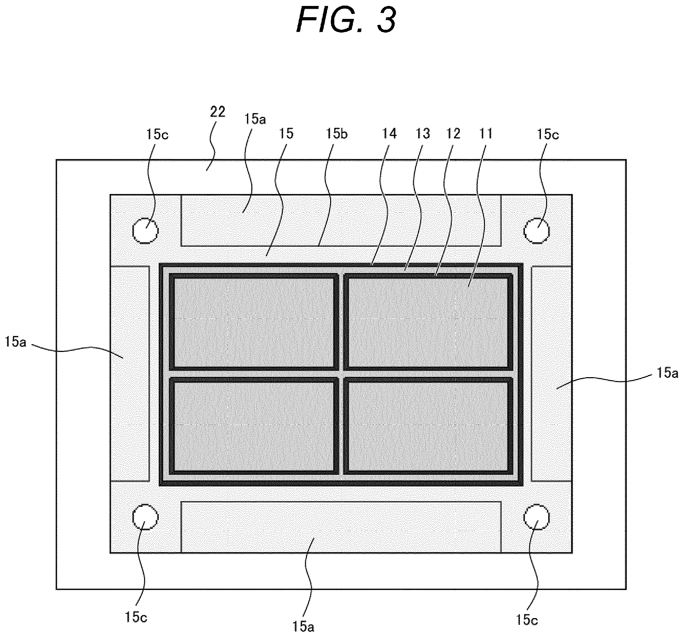

FIG. 3 is a top view of a power semiconductor module in Embodiment 2. The difference from Embodiment 1 is that the base-plate chamfered portion 15a is not formed around the base plate fixing hole 15c. According to such a configuration, there is no problem in screwing as described in Embodiment 1. Thus, in a region other than the periphery of the base plate fixing hole 15c, the base-plate chamfered portion end 15b may enter in a region surrounded by joining the centers 15f of the base plate fixing holes 15c at the four corners to each other by a straight line. Other configurations are similar to those in Embodiment 1, and thus the description thereof will be omitted.

An operation of the power semiconductor module in the present embodiment will be described below. The present embodiment discloses a configuration in which, in the region other than the periphery of the base plate fixing hole 15c, the base-plate chamfered portion end 15b enters the region surrounded by joining the centers 15f of the base plate fixing holes 15c at the four corners to each other by a straight line. In the present embodiment, when the upper surface of the power semiconductor module is viewed, the chamfered portion 15a can be provided near the semiconductor chip 11. Thus, it is possible to increase the volume for accommodating the leaked thermal conductive grease 21. Therefore, it is possible to sufficiently secure a volume for accommodating the thermal conductive grease at a smaller angle α.

On the other hand, since the main path through which the heat generated from the semiconductor chip 11 is dissipated to the heat sink 22 is also secured in the configuration of the present embodiment, the influence on the thermal resistance is small.

Further, the present embodiment discloses a structure in which the chamfered portion 15a of the base plate 15 is not formed around the base plate fixing hole 15c. With this structure, when the base plate fixing hole 15c is screwed, a force pushing down the base plate 15 outside the base plate fixing hole 15c does not act, that is, a force pushing up the base plate 15 inside the base plate fixing hole 15c does not act. Thus, a gap is hardly generated between the surface 15d of the second main surface of the base plate 15 other than the chamfered portion and the heat sink 22, and the thermal resistance is not increased. Further, a load is less likely to be applied to the vicinity of the base plate fixing hole 15c, and the reliability is not deteriorated.

### Embodiment 3

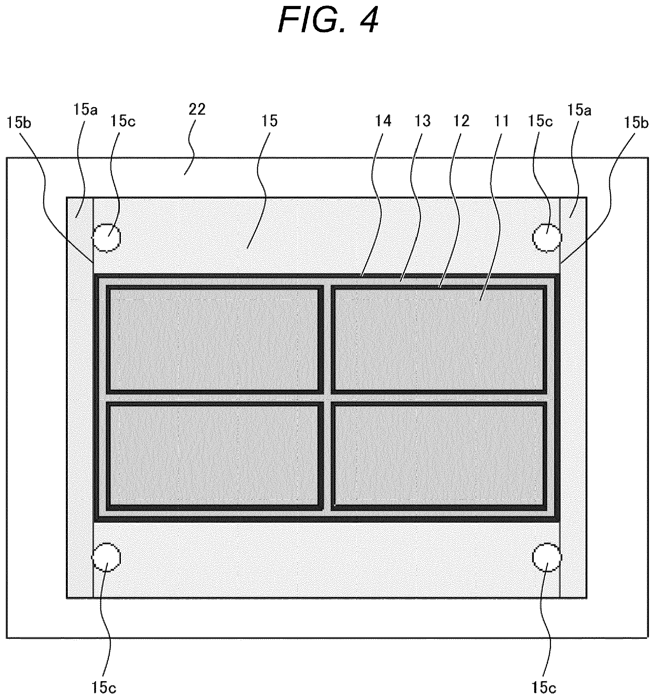

FIG. 4 is a top view of a power semiconductor module in Embodiment 3. The difference from Embodiment 1 is that the chamfered portion 15a of the base plate 15 is provided on a side of the base plate 15 on a side where the distance between the semiconductor chip 11 and the side surface of the base plate 15 is small among the sides of the base plate 15. Other configurations are similar to those in Embodiment 1, and thus the description thereof will be omitted.

An operation of the power semiconductor module in the present embodiment will be described below. The chamfered portions 15a formed on the four sides of the base plate 15 in Embodiment 1 are reduced such that the chamfered portions 15a are formed on two sides in the present embodiment. Since the temperature of the thermal conductive grease 21 increases and the viscosity decreases due to the heat generation of the semiconductor chip 11, the thermal conductive grease 21 is more likely to leak from the side on the side where the distance between the semiconductor chip 11 and the side surface of the base plate 15 is small (the short side of the base plate 15 in FIG. 4) when the pump-out occurs. In the present embodiment, since the chamfered portion 15a is provided on the side where the thermal conductive grease 21 easily leaks out among the sides of the base plate 15, it is possible to suppress leakage of the thermal conductive grease 21 to the outside.

Note that, in the present embodiment, the base-plate chamfered portions 15a are provided on the two sides on the short side of the base plate 15. However, when the power semiconductor chip 11 is disposed at a position closer to the long side than the short side of the base plate 15, if the chamfered portions 15a are provided on the two sides on the long side, it is possible to effectively suppress the leakage of the thermal conductive grease to the outside.

### Embodiment 4

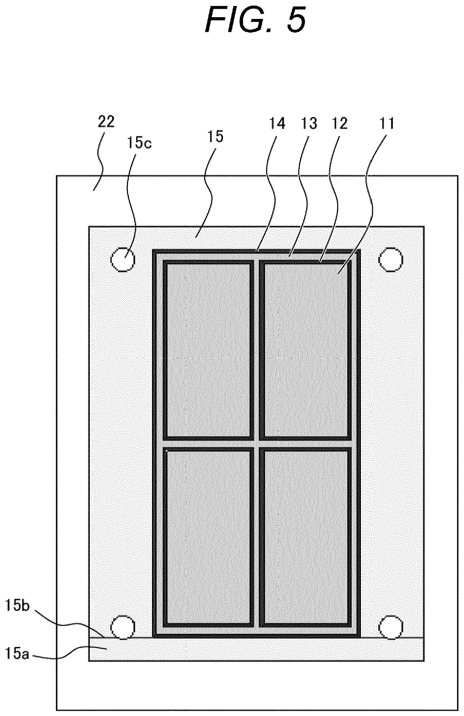

FIG. 5 is a top view of a power semiconductor module in Embodiment 4. The difference from Embodiment 3 is that the chamfered portion 15a of the base plate 15 is formed only on one side of the short side of the base plate 15, and a direction thereof is a downward direction when the power semiconductor module is mounted (installed). Other configurations are similar to those in the third embodiment, and thus the description thereof will be omitted.

An operation of the power semiconductor module in the present embodiment will be described below. The chamfered portions formed on the two sides in Embodiment 3 are reduced such that the chamfered portion is formed on one side in Embodiment 4. On the side directed upward during mounting among the sides of the base plate 15, even though the thermal conductive grease 21 leaks due to the pump-out, flowing out of the thermal conductive grease 21 is prevented by being blocked by a component (for example, the base plate 15 itself) located below. Therefore, as in the present embodiment, by providing the base-plate chamfered portion 15a at least on the side directed downward during mounting among the sides of the base plate 15, the region for storing the thermal conductive grease 21 is formed, so that the downward leakage of the thermal conductive grease 21 is suppressed.

### Embodiment 5

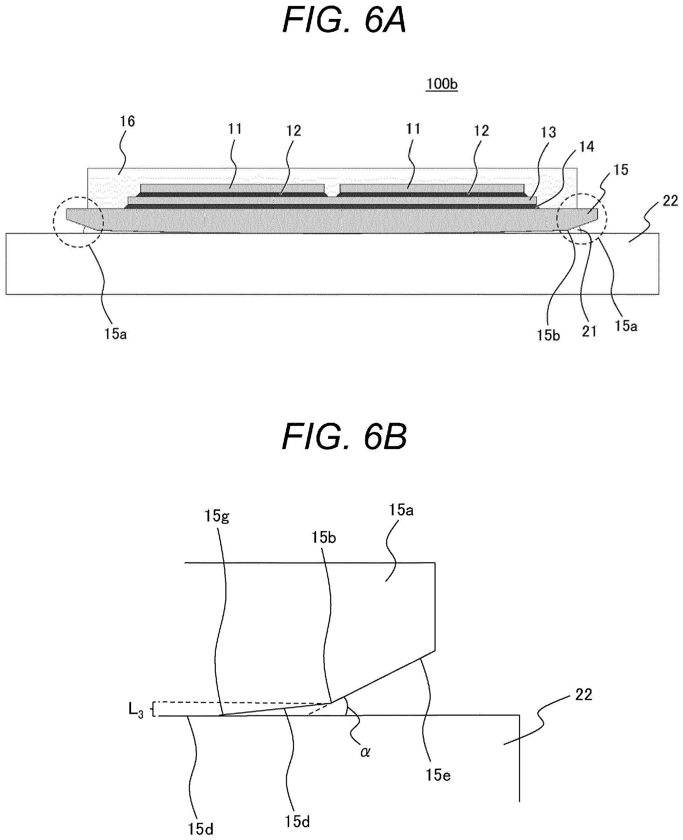

FIG. 6A is a cross-sectional view of Embodiment 5, and FIG. 6B is an enlarged view of a periphery of a chamfered portion of a heat dissipation plate in FIG. 6A. A difference from Embodiment 1 is that, in a power semiconductor module 100b, in a state before the base plate 15 is fixed to the heat sink 22 by screwing or the like, a surface of the second main surface of the base plate 15 other than the chamfered portion protrudes toward the heat sink 22 in a substantially spherical shape. Other configurations are similar to those in Embodiment 1, and thus the description thereof will be omitted.

FIG. 6B illustrates a state in which the base plate 15 is fixed to the heat sink 22. In this state, the base plate 15 is deformed, and a portion that is in close contact with the heat sink 22 more than before fixing is increased. When the entirety of the surface 15d of the second main surface of the base plate 15 other than the chamfered portion is brought into close contact with the heat sink 22, the same shape as in Embodiment 1 is obtained, and the same effect can be obtained. Further, as illustrated in FIG. 6B, a part thereof may not be in close contact with the heat sink 22, and the outside of an end portion 15g may not be in close contact with the heat sink 22. In this case, in a state where the base plate 15 is fixed to the heat sink 22, a distance L3 from the upper surface of the heat sink 22 to the base-plate chamfered portion end 15b in the thickness direction is desirably 0.05 mm or more and less than 0.5 mm.

Also in the present embodiment, similarly to Embodiment 1, in a state where the base plate 15 is fixed to the heat sink 22, when the cross section of the base plate 15 is viewed, the inclination of the second main surface of the base plate 15 is discontinuous at the boundary (position of the chamfered portion end 15b) between the chamfered portion 15a and the surface 15d of the second main surface of the base plate 15 other than the chamfered portion, and the angle α formed by the bottom surface 15e of the chamfered portion 15a of the base plate 15 and the surface of the heat sink 22 (upper surface of the heat sink 22) on the side where the base plate 15 is fixed is 5° or more and 30° or less.

An operation of the power semiconductor module 100b in the present embodiment will be described below. Before screwing, the surface 15d of the second main surface of the base plate 15 other than the chamfered portion protrudes toward the heat sink 22 in a spherical shape. With this structure, the base plate is bent and fixed at the time of screwing. The reaction force at this time can increase an adhesive force between the base plate 15 and the heat sink 22, and it is possible to increase heat dissipation performance.

In addition, even though the surface 15d of the second main surface of the base plate 15 other than the chamfered portion protrudes in a spherical shape, the inclination is discontinuous with the base-plate chamfered portion 15a, and thus a space can be provided between the base-plate chamfered portion 15a and the heat sink 22 even after screw fastening. Therefore, even though the pump-out occurs during the operation, it is possible to store the thermal conductive grease 21, and to suppress the leakage of the thermal conductive grease 21 to the outside.

The structure in which the surface 15d of the second main surface of the base plate 15 other than the chamfered portion protrudes in a spherical shape and is connected to the base-plate chamfered portion 15a at the base-plate chamfered portion end 15b is disclosed. The chamfered portion 15a is chamfered substantially linearly. This effect is advantageous in that machining cost can be reduced by machining the base-plate chamfered portion substantially linearly rather than machining the entire surface of the base plate 15 into a spherical shape.

As described above, according to the present invention, it has been described that it is possible to provide a power semiconductor module that secures a space capable of accumulating a thermal conductive grease disposed between a heat dissipation plate and a cooler while securing a sufficient contact area between the heat dissipation plate and the cooler.

Note that the embodiments of the power semiconductor module in the present invention have been described in detail above with reference to the drawings. The specific configuration is not limited to the embodiments and the design changes and the like without departing from the gist of the present disclosure are included in the present disclosure.

### Reference Signs List

100a, 100b power semiconductor module
11 power semiconductor chip
12 solder under chip
13 insulating substrate
14 solder under substrate
15 base plate
15a base-plate chamfered portion
15b base-plate chamfered portion end
15c base plate fixing hole
15d surface of second main surface of base plate 15 other than chamfered portion
15e bottom surface of base-plate chamfered portion 15a
15f center of base plate fixing hole
15g end portion of surface other than chamfered portion of base plate
16 sealing resin
17 main terminal
18 wire bonding
21 thermal conductive grease
22 heat sink

## Claims

1. A power semiconductor module comprising:
a base plate;
a semiconductor chip mounted on a first main surface of the base plate; and
a heat sink connected to a second main surface of the base plate,
wherein a chamfered portion is provided at an end portion of at least one side of the second main surface, and
in a state where the base plate is fixed to the heat sink, when a cross section of the base plate is viewed, an inclination of the second main surface of the base plate is discontinuous at a boundary between the chamfered portion and a region of the second main surface of the base plate other than the chamfered portion, and an angle formed between a bottom surface of the chamfered portion of the base plate and a surface of the heat sink on a side where the base plate is fixed is 5° or more and 30° or less.

2. The power semiconductor module according to claim 1, wherein a surface of the second main surface of the base plate other than the chamfered portion is a flat surface in a state before the base plate is fixed to the heat sink.

3. The power semiconductor module according to claim 1, further comprising a protrusion portion in which a surface of the second main surface of the base plate other than the chamfered portion protrudes toward the heat sink in a substantially spherical shape in a state before the base plate is fixed to the heat sink.

4. The power semiconductor module according to claim 1, wherein the semiconductor chip is disposed not to overlap with the chamfered portion of the base plate.

5. The power semiconductor module according to claim 1, wherein
four corners of the base plate have screw holes for screw fastening to the heat sink, and
a boundary between the chamfered portion and a surface of the second main surface of the base plate other than the chamfered portion is provided outside a region surrounded by joining centers of the screw holes to each other by a straight line.

6. The power semiconductor module according to claim 1, wherein
four corners of the base plate have screw holes for screw fastening to the heat sink, and
the chamfered portion is not formed around the screw holes.

7. The power semiconductor module according to claim 1, wherein
four corners of the base plate have screw holes for screw fastening to the heat sink,
the chamfered portion is formed in a region other than a periphery of the screw hole, and
a boundary between the chamfered portion and a surface of the second main surface of the base plate other than the chamfered portion is provided inside a region surrounded by joining centers of the screw holes to each other by a straight line.

8. The power semiconductor module according to claim 1, wherein the chamfered portion of the base plate is provided on a side where a distance between the semiconductor chip and a side surface of the base plate is small among sides of the base plate.

9. The power semiconductor module according to claim 1, wherein the chamfered portion is provided on at least a side that is in a downward direction when the power semiconductor module is mounted among sides of the base plate.

10. The power semiconductor module according to claim 1, wherein a maximum value of a distance between a bottom surface of the chamfered portion and an upper surface of the heat sink is 0.5 mm or more and 2.5 mm or less.

11. The power semiconductor module according to claim 1, wherein a material of the base plate is AlSiC or MgSiC.
